(19) Europäisches Patentamt
European Patent Office
Office européen des brevets

(11) EP 3 940 768 B1

(12) EUROPEAN PATENT SPECIFICATION

(45) Date of publication and mention of the grant of the patent:
**26.06.2024 Bulletin 2024/26**

(21) Application number: **20783634.7**

(22) Date of filing: **25.03.2020**

(51) International Patent Classification (IPC):
***C04B 38/06*** *(2006.01)* ***C04B 41/83*** *(2006.01)*
***C04B 41/00*** *(2006.01)* ***C04B 41/48*** *(2006.01)*
***B32B 15/16*** *(2006.01)* ***B32B 15/20*** *(2006.01)*
***C04B 35/583*** *(2006.01)* ***B32B 5/16*** *(2006.01)*
*C04B 111/00 (2006.01)* *H01L 23/373 (2006.01)*
*H01L 23/42 (2006.01)*

(52) Cooperative Patent Classification (CPC):
(C-Sets available)
**C04B 38/0645; B32B 5/16; B32B 15/16; B32B 15/20; C04B 35/583; C04B 41/009; C04B 41/4853; C04B 41/488; C04B 41/4884; C04B 41/83;** B32B 2260/025; B32B 2260/046; B32B 2264/107; B32B 2307/206; B32B 2457/00;

(Cont.)

(86) International application number:
**PCT/JP2020/013480**

(87) International publication number:
**WO 2020/203586 (08.10.2020 Gazette 2020/41)**

(54) **COMPOSITE, METHOD FOR PRODUCING COMPOSITE, LAMINATE, AND METHOD FOR PRODUCING LAMINATE**

VERBUNDSTOFF, VERFAHREN ZUR HERSTELLUNG DES VERBUNDSTOFFS, LAMINAT UND VERFAHREN ZUR HERSTELLUNG VON LAMINAT

COMPOSITE, PROCÉDÉ DE PRODUCTION DE COMPOSITE, STRATIFIÉ ET PROCÉDÉ DE PRODUCTION DE STRATIFIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2019 JP 2019067602**

(43) Date of publication of application:
**19.01.2022 Bulletin 2022/03**

(73) Proprietor: **Denka Company Limited**
**Tokyo 103-8338 (JP)**

(72) Inventors:
- **MINAKATA, Yoshitaka**
  **Tokyo 103-8338 (JP)**
- **SASAKI, Eri**
  **Tokyo 103-8338 (JP)**
- **INOUE, Saori**
  **Tokyo 103-8338 (JP)**
- **OKI, Mana**
  **Tokyo 103-8338 (JP)**

(74) Representative: **Hoffmann Eitle**
**Patent- und Rechtsanwälte PartmbB**
**Arabellastraße 30**
**81925 München (DE)**

(56) References cited:
**EP-A1- 3 428 223**
**WO-A1-2014/142123**
**WO-A1-2017/155110**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
C04B 2111/00844; C04B 2235/3208;
C04B 2235/3409; C04B 2235/386; C04B 2235/442;
C04B 2235/5436; C04B 2235/604;
C04B 2235/6567; C04B 2235/658;
C04B 2235/6586; C04B 2235/767; H01L 23/3735;
H01L 23/42

C-Sets
**C04B 38/0645, C04B 35/583, C04B 38/0054;**
**C04B 41/009, C04B 35/581, C04B 38/00;**
**C04B 41/009, C04B 35/583, C04B 38/00;**
**C04B 41/009, C04B 35/584, C04B 38/00**

## Description

### Technical Field

The present disclosure relates to a composite, a method for producing a composite, a laminate, and a method for producing a laminate.

### Background Art

In electronic components of LED lighting devices, in-vehicle power modules, and the like, efficient dissipation of heat generated during use has been a problem to be solved. With regard to this problem, measures have been taken, such as a method of increasing the thermal conductivity of an insulating layer of a printed wiring board on which an electronic component is mounted thereon, and a method of attaching an electronic component or a printed wiring board to a heat sink by means of electrically insulating thermal interface materials. In such an insulating layer and a thermal interface material, a composite (heat dissipation member) composed of a resin and a ceramic such as boron nitride is used.

As such a composite, a material obtained by dispersing a ceramic powder in a resin has been conventionally used. In recent years, investigation has been conducted on composites obtained by sintering a porous ceramic sintered body (for example, boron nitride sintered body) with a resin (for example, Patent Literature 1).

EP 3 428 223A relates to a ceramic-resin composite body comprising a sintered body having a monolithic structure in which three-dimensionally continuous non-oxide ceramic primary particles have a specific average major diameter and aspect ratio. The sintered body is impregnated with a thermosetting resin composition having a minimum exothermic onset temperature of 180 °C, a specific curing rate and number average molecular weight.

### Citation List

### Patent Literature

Patent Literature 1: International Publication WO 2014/196496

### Summary of Invention

### Technical Problem

With regard to composites such as described above, there is still room for improvement from the viewpoint of achieving both adhesiveness and insulation properties.

It is an object of the present disclosure to provide a composite having excellent adhesiveness to an adherend and excellent insulation properties after adhesion to the adherend, and a method for producing the composite.

### Solution to Problem

According to an aspect of the present disclosure, there is provided a composite including a nitride sintered body having a porous structure and a semi-cured product of a heat-curable composition impregnated into the nitride sintered body, wherein a dielectric breakdown voltage obtainable after disposing the composite between adherends, heating and pressurizing the composite for 5 minutes under the conditions of 200°C and 10 MPa, and further heating the composite for 2 hours under the conditions of 200°C and atmospheric pressure, is greater than 5 kV. The semi-cured product has a structural unit derived from a cyanate group, a structural unit derived from a bismaleimide group, and a structural unit derived from an epoxy group. The content of the semi-cured product is 20% to 70% by volume.

Since the composite includes a semi-cured product of a heat-curable composition, the composite has excellent adhesiveness to an adherend. Since the composite has a specific dielectric breakdown voltage in adhesion under the above-mentioned conditions, the composite has excellent insulation properties after adhesion to an adherend.

The semi-cured product has a structural unit derived from a cyanate group, a structural unit derived from a bismaleimide group, and a structural unit derived from an epoxy group. As the semi-cured product contains the specific structural units, the insulation properties and adhesiveness of the composite to an adherend can be enhanced.

The semi-cured product may contain at least one curing agent selected from the group consisting of a phosphine-based curing agent and an imidazole-based curing agent. When the semi-cured product contains the specific curing agent, adhesion of the above-mentioned composite to an adherend can be carried out in a shorter period of time.

The content of the semi-cured product is 20% to 70% by volume. When the content of the semi-cured product is in the range, upon being adhered to an adherend, the semi-cured product may be caused to be appropriately present

at the interface with the adherend, and the adhesiveness of the composite to the adherend may be enhanced. Furthermore, when the content of the semi-cured product is in the above-described range, the composite may also have superior insulation properties after adhesion to the adherend.

According to an aspect of the present disclosure, there is provided a method for producing a composite having a nitride sintered body having a porous structure and a semi-cured product of a heat-curable composition impregnated into the nitride sintered body, the method including impregnating a nitride sintered body having a porous structure with a heat-curable composition; and heating the heat-curable composition to a heating temperature of 80°C to 130°C to semi-cure the heat-curable composition, wherein the impregnating is a step of impregnating the nitride sintered body with the heat-curable composition by setting the temperature of the heat-curable composition to be higher than the heating temperature and lower than or equal to (the heating temperature + 20°C), and the heat-curable composition contains a compound having a cyanate group, a compound having a bismaleimide group, and a compound having an epoxy group; and at least one curing agent selected from the group consisting of a phosphine-based curing agent and an imidazole-based curing agent. The content of the semi-cured product is 20% to 70% by volume.

The method for producing a composite has impregnating a nitride sintered body having a porous structure with a heat-curable composition, and semi-curing the heat-curable composition, and a composite may be easily produced by impregnating a nitride sintered body with a heat-curable composition and then curing the heat-curable composition. Furthermore, since the resulting composite includes a semi-cured product of the heat-curable composition, the composite has excellent adhesiveness to an adherend. Since the composite has a specific dielectric breakdown voltage in adhesion under the above-mentioned conditions, the composite has excellent insulation properties after adhesion to an adherend.

According to an aspect of the present disclosure, there is provided a laminate including a first metal base material; an interlayer; and a second metal base material in this order, wherein the first metal base material and the second metal base material are adhered by the interlayer, and the interlayer is a cured product of the composite.

Since the laminate is such that a cured product of the composite is the interlayer, the laminate has excellent adhesiveness between the first metal base material and the second metal base material and has excellent insulation properties after adhesion.

According to an aspect of the present disclosure, there is provided a method for producing a laminate including a first metal base material, an interlayer, and a second metal base material in this order, the method including disposing the first metal base material, the above-mentioned composite, and the second metal base material in this order, heating and pressurizing the assembly to cure the composite, and forming the interlayer.

In the method for producing a laminate, since the above-mentioned composite is employed as the interlayer, a laminate having excellent adhesiveness between the first metal base material and the second metal base material and having excellent insulation properties after adhesion may be provided.

## Advantageous Effects of Invention

According to the present disclosure, a composite having excellent adhesiveness to an adherend and excellent insulation properties after adhesion to the adherend, and a method for producing the composite may be provided.

## Description of Embodiments

Hereinafter, embodiments of the present disclosure will be described. However, the following embodiments are merely for describing the present disclosure and are not intended to limit the present disclosure to the following matters.

An embodiment of the composite is a composite including a nitride sintered body having a porous structure; and a semi-cured product of a heat-curable composition impregnated into the nitride sintered body. The composite is such that the dielectric breakdown voltage obtainable after disposing the composite between adherends, heating and pressurizing the composite for 5 minutes under the conditions of 200°C and 10 MPa, and further heating the composite for 2 hours under the conditions of 200°C and atmospheric pressure, is greater than 5 kV.

The term "semi-cured" (also referred to as stage B) state according to the present specification means a state in which a material may be further cured by a subsequent curing treatment. A material that is in a semi-cured state may also be utilized and adhered to an adherend by temporarily pressure-bonding the material to the adherend and then heating the material. The semi-cured product is in a semi-cured state and may be brought to a "completely cured" (also referred to as stage C) state by being further subjected to a curing treatment. Whether a semi-cured product in a composite is in a semi-cured state that may be further cured may be checked by, for example, using a differential scanning calorimeter.

Since the composite includes the semi-cured product of a heat-curable composition impregnated into a nitride sintered body, the composite is capable of adhering to an adherend. Since the composite includes a nitride sintered body, and the pores present in the nitride sintered body are filled with the above-mentioned semi-cured product of a heat-curable composition, the composite has a relatively high dielectric breakdown voltage after adhesion to an adherend

and excellent insulation properties. Furthermore, since the composite includes a nitride sintered body, the composite also has a relatively low thermal resistance and excellent thermal conductivity. The composite of the present embodiment is useful as an adhesive member which is required to have thermal conductivity and insulation properties (for example, an adhesive sheet and the like). Specifically, the composite of the present embodiment may be used as an adhesive member that adheres a metal circuit board and other layers in a power module structure, an LED light-emitting device, and the like.

The shape of the composite may be, for example, a block shape, a sheet shape, and the like. In a case where the composite has a sheet shape, the thickness of the composite may be, for example, 0.1 mm or more, 0.2 mm or more, or 0.3 mm or more. When the thickness of the composite is in the above-described range, the composite may maintain insulation properties even when used for use applications where high voltage is applied. In a case where the composite has a sheet shape, the thickness of the composite may be, for example, 1.0 mm or less, 0.7 mm or less, or 0.4 mm or less. When the thickness of the composite is in the above-described range, the thermal resistance may be made smaller.

The nitride sintered body having a porous structure may be a product obtained when primary particles of a nitride are sintered together. The term "porous structure" according to the present specification means a structure having a plurality of fine holes (hereinafter, also referred to as pores) and includes a structure in which at least a portion of the pores are connected to form continuous pores. The average pore size of the pores may be, for example, 7 μm or less, 6 μm or less, or 5 μm or less. When the average pore size is in the above-described range, the thermal conductivity of the composite may be enhanced. The average pore size of the pores may be, for example, 0.3 μm or more, 0.5 μm or more, or 0.7 μm or more. When the average pore size is in the above-described range, the pores may be easily filled with a heat-curable composition, and the adhesiveness of the composite to an adherend may be further enhanced. The "average pore size" according to the present specification means a value that is measured according to a mercury intrusion method.

A semi-cured product of a heat-curable composition (hereinafter, may be simply referred to as "semi-cured product") means that a curing reaction of a heat-curable composition has proceeded to a certain level or more, as will be described below. Therefore, the semi-cured product of the heat-curable composition may contain a heat-curable resin obtainable by causing raw material components in the heat-curable composition (compounds and the like included in the heat-curable composition) to react, and the like. The semi-cured product may contain compounds and the like of an unreacted portion among the raw material components, in addition to the heat-curable resin.

The semi-cured product of the heat-curable composition has a structural unit derived from a cyanate group, a structural unit derived from a bismaleimide group, and a structural unit derived from an epoxy group. As the semi-cured product of the heat-curable composition has a structural unit derived from a cyanate group, a structural unit derived from a bismaleimide group, and a structural unit derived from an epoxy group, production of the composition is made easy, and the adhesiveness of the composite to an adherend may be further enhanced.

The semi-cured product has a structural unit derived from a cyanate group, a structural unit derived from a bismaleimide group, and a structural unit derived from an epoxy group. As the semi-cured product contains these structural units to a certain level or more, the dielectric breakdown voltage that will be described below may be further enhanced. Even when the content of the semi-cured product in the composite is small, an excellent dielectric breakdown voltage may be exhibited.

Examples of the structural unit having a cyanate group include a urethane bond (-NH-CO-). Examples of the structural unit derived from a bismaleimide group include a structure represented by the following Formula (1). Examples of the structural unit derived from an epoxy group include a structure represented by the following Formula (2). These structural units may be detected by using $^{1}$H-NMR and $^{13}$C-NMR. Furthermore, the structural units may also be detected using GPC (gel permeation chromatography). The above-mentioned structural units may be detected by either NMR or GPC.

[Chemical Formula 1]

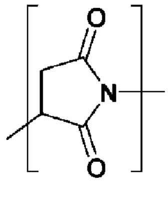

(1)

[Chemical Formula 2]

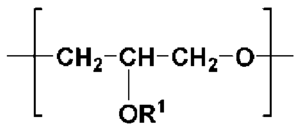 (2)

In the above-described General Formula (2), $R^1$ represents a hydrogen atom or another functional group. Examples of the other functional group may be an alkyl group and the like.

The semi-cured product may have another structural unit other than the structural unit derived from a cyanate group, the structural unit derived from a bismaleimide group, and the structural unit derived from an epoxy group mentioned above.

The semi-cured product may contain a heat-curable resin and contains a cyanate resin, a bismaleimide resin, and an epoxy resin. The semi-cured product may contain, for example, a phenol resin, a melamine resin, a urea resin, an alkyd resin, and the like, in addition to the heat-curable resin.

The semi-cured product may contain at least one curing agent selected from the group consisting of a phosphine-based curing agent and an imidazole-based curing agent. A phosphine-based curing agent may accelerate a triazine production reaction based on trimerization of a compound having a cyanate group. Examples of the phosphine-based curing agent include tetraphenylphosphonium tetra-p-tolylborate. An imidazole-based curing agent produces oxazoline and accelerates a curing reaction of a compound having an epoxy group. Examples of the imidazole-based curing agent include 1-(1-cyanomethyl)-2-ethyl-4-methyl-1H-imidazole. The semi-cured product may be a cured product formed by curing a polymerizable compound (for example, a compound having a cyanate group, a compound having an epoxy group, or the like) included in the heat-curable composition.

Regarding the degree of curing of the semi-cured product, for example, the curing rate of a heat-curable composition having a curing rate of 100% when the heat-curable composition is in a completely cured state, may be adopted as an index. The curing rate of the semi-cured product may be, for example, 70% or less, 65% or less, or 60% or less. When the curing rate of the semi-cured product is in the above-described range, adhesiveness of the composite to an adherend may be enhanced. Furthermore, as the semi-cured product moves within the resin composite, the semi-cured product may embed voids in the resin composite and increase the dielectric breakdown voltage. Furthermore, the curing rate of the semi-cured product of the resin may be, for example, 5% or more, 15% or more, 30% or more, or 40% or more. When the curing rate of the semi-cured product is in the above-described range, the semi-cured product is suppressed from flowing out of the resin composite, and the semi-cured product may be sufficiently retained in the pores of the nitride sintered body.

The curing rate may be determined by making measurement using a differential scanning calorimeter. First, the quantity of heat Q generated when 1 g of a heat-curable composition in an uncured state is completely cured is measured. Next, 1 g of a semi-cured product is collected from the composite to be measured, and the quantity of heat R generated when the collected semi-cured product is completely cured is measured. For the measurement, a differential scanning calorimeter is used. Subsequently, the curing rate of the semi-cured product may be calculated by the following Formula (A). Meanwhile, whether the semi-cured product has been completely cured may be checked by seeing that heat generation comes to an end in an exothermic curve obtainable by differential scanning calorimetry.

$$\text{Curing rate of semi-cured product [\%]} = [Q - R]/Q] \times 100 \cdots (A)$$

The curing rate may be calculated as follows. That is, the curing rate of the semi-cured product impregnated into the nitride sintered body may be determined by the following method. First, the quantity of heat generation Q2 occurring when an uncured heat-curable composition is heated to be completely cured is determined. Then, the quantity of heat generation R2 occurring when a sample collected from the semi-cured product included in the composite is similarly heated to be completely cured is determined. At this time, the mass of the sample used for the measurement by a differential scanning calorimeter is set to be the same as that of the heat-curable composition used for the measurement of the quantity of heat generation Q2. Assuming that components having heat-curability are included in the semi-cured product at a content of c (mass%), the curing rate of the heat-curable composition impregnated into the composite is determined by the following Formula (B).

$$\text{Curing rate (\%) of impregnated semi-cured product} = \{1 - [(R2/c) \times 100]/Q2\} \times 100 \qquad (B)$$

The content of the semi-cured product is 20% by volume or more, and may be, for example, 25% by volume or more, 30% by volume or more, 35% by volume or more, or 40% by volume or more, based on the composite. When the content of the heat-curable composition is in the above-described range, the adhesiveness at the time of adhering to an adherend by heating and pressurization may be further enhanced. The content of the heat-curable composition is 70% by volume or less, and may be, for example, 65% by volume or less, 60% by volume or less, or 55% by volume or less, based on the composite. When the content of the heat-curable composition is in the above-described range, both the adhesiveness and the insulation properties of the composite may be achieved at a higher level. Furthermore, when the content of the heat-curable composition is in the above-described range, the heat dissipation properties of a laminate obtainable using the composite may be sufficiently suppressed. The content of the heat-curable composition is adjusted within the above-mentioned range of 20% to 70% by volume. The content of the semi-cured product is obtained by volatilizing the semi-cured product by heating the resin composite at about 600°C and measuring the difference of weights obtained before and after the volatilization.

The content of the heat-curable composition in the above-mentioned composite may be regarded as the porosity of the nitride sintered body and may be calculated from the following Formula (C). The true density of the nitride sintered body is, for example, 2.28 g/cm$^3$ in the case of boron nitride.

Content of heat-curable composition [volume%] = porosity of nitride sintered body = [1 - (D/true density of nitride sintered body] (C)

In the above-described Formula (C), D means the bulk denisty of the nitride sintered body represented by the following Formula (D).

Bulk density of nitride sintered body [g/cm$^3$] = mass of nitride sintered body/volume of nitride sintered body (D)

In the above-described Formula (C), in a case where the nitride sintered body is obtained from a plurality of nitrides, the true density of the nitride sintered body means a value calculated by multiplying the respective true densities of the nitrides by the respective blending ratios (mass ratios). For example, in the case of mixing nitride A and nitride B respectively at the mass ratio of a : b, the true density of the nitride sintered body is determined by the following Formula (D).

True density of nitride sintered body [g/cm$^3$] = $(A \times a + B \times b) \div (a + b)$ (D)

The adhesiveness of the composite may be evaluated by using the cohesive fracture area ratio (area%) on the peeling surface at the time of peeling off a sample according to JIS K 6854-1:1999 "Adhesives - Determination of peel strength of bonded assemblies", as an index. The cohesive fracture area ratio on the peeling surface of the composite may be adjusted to, for example, 40% by area or more, 50% by area or more, or 60% by area or more, with respect to the total area of the adhering surface of the adherend.

The dielectric breakdown voltage between adherends after adhesion of the composite is greater than 5 kV and may be set to 5.5 kV or greater or 6 kV or greater. The dielectric breakdown voltage between adherends after adhesion of the composite may be, for example, 12 kV or less or 10 kV or less. The dielectric breakdown voltage of the composite may be adjusted by means of, for example, the composition of the heat-curable composition, the content of the semi-cured product, and the like. The "dielectric breakdown voltage" according to the present specification means a value measured by a withstanding voltage tester (manufactured by KIKUSUI ELECTRONICS CORPORATION, apparatus name: TOS-8700) according to JIS C2110-1:2016.

Regarding a test specimen used for the measurement of the dielectric breakdown voltage, a test specimen prepared by the following technique is used. First, the composite is disposed between two sheets of copper plates, the assembly is heated and pressurized for 5 minutes under the conditions of 200°C and 10 MPa and further heated for 2 hours under the conditions of 200°C and atmospheric pressure to prepare a laminate. Pressure is applied in the direction of lamination of the two sheets of copper plates and the composite. On one surface of the laminate, an etching resist agent is screen-printed so as to have a circular shape having a diameter of 20 mm, and on the other surface of the laminate, the etching resist agent is screen-printed over the entire surface (so-called solid pattern shape). After printing, the etching resist agent is irradiated with ultraviolet radiation to cure, and resist is formed. After the resist is formed, the copper plate on the side on which a circular-shaped resist has been formed is etched with a cupric chloride solution, and a circular-shaped copper circuit having a diameter of 20 mm is formed on one surface of the laminate. The laminate having a circular-shaped copper circuit is used as an object of measurement.

The thermal resistance after adhesion of the composite may be adjusted to, for example, 0.50 K/W or less,

0.40 K/W or less, 0.37 K/W or less, or 0.35 K/W or less. The thermal resistance of the composite may be adjusted by means of, for example, the composition of the heat-curable composition, the content of the semi-cured product, the density of the nitride sintered body, and the like. The "thermal resistance" according to the present specification means a value measured by a resin material thermal resistance analyzer (manufactured by Hitachi Technologies and Services, Ltd.) according to ASTM D5470. For the measurement of thermal resistance, a laminate obtained by disposing the composite between two sheets of copper plates (both copper plates having a thickness of 1 mm), heating and pressurizing the assembly for 5 minutes under the conditions of 200°C and 10 MPa, and further heating the assembly for 2 hours under the conditions of 200°C and atmospheric pressure, is used as an object of measurement.

The above-mentioned composite may be produced by, for example, the following production method. An embodiment of the method for producing the composite is a method for producing a composite having a nitride sintered body having a porous structure and a semi-cured product of a heat-curable composition impregnated into the nitride sintered body, and the method has impregnating a nitride sintered body having a porous structure with a heat-curable composition (hereinafter, also referred to as impregnation); and heating the heat-curable composition to a heating temperature of 80°C to 130°C to be semi-cured (hereinafter, also referred to as semi-curing). The impregnating is a step of impregnating the heat-curable composition by adjusting the temperature of the heat-curable composition to be higher than the heating temperature for the semi-curing and lower than or equal to (the heating temperature + 20°C). The heat-curable composition contains a compound having a cyanate group, a compound having a bismaleimide group, and a compound having an epoxy group; and at least one curing agent selected from the group consisting of a phosphine-based curing agent and an imidazole-based curing agent.

The nitride sintered body having a porous structure may be a product obtained when primary particles of a nitride are sintered together. Regarding the nitride sintered body having a porous structure, a commercially available nitride sintered body may be used, or separately, a product prepared by sintering a powder containing a nitride may be used. That is, the method for producing a composite may have sintering a powder containing a nitride (hereinafter, also referred to as nitride powder) to obtain a nitride sintered body having a porous structure. Regarding the nitride sintered body, a nitride sintered body having a porous structure may be prepared by spheroidizing a slurry including a nitride powder using a spray dryer or the like, further molding the slurry spheroids, and then sintering the slurry spheroids. For the molding, a mold may be used, or a cold isostatic pressing (CIP) method may be used.

The nitride may contain at least one nitride selected from the group consisting of, for example, boron nitride, aluminum nitride, and silicon nitride, and preferably contains boron nitride. Regarding boron nitride, amorphous boron nitride and hexagonal boron nitride may all be used. The thermal conductivity of the nitride may be, for example, 40 W/(m·K) or greater, 50 W/(m·K) or greater, or 60 W/(m·K) or greater. When a nitride having excellent thermal conductivity as described above is used as the nitride, the thermal resistance of the resulting composite may be further decreased.

At the time of sintering the nitride powder, a sintering aid may be used. The sintering aid may be, for example, oxides of rare earth elements, such as yttria oxide, alumina oxide, and magnesium oxide; carbonates of alkali metals, such as lithium carbonate and sodium carbonate; boric acid; and the like. In the case of incorporating a sintering aid, the amount of addition of the sintering aid may be, for example, 0.01 parts by mass or more, or 0.1 parts by mass or more, for example, with respect to 100 parts by mass of the sum of the nitride and the sintering aid. The amount of addition of the sintering aid may be, for example, 20 parts by mass or less, 15 parts by mass or less, or 10 parts by mass or less, with respect to 100 parts by mass of the sum of the nitride and the sintering aid. When the amount of addition of the sintering aid is adjusted to be in the above-described range, it becomes easy to adjust the average pore size of the nitride sintered body to the above-mentioned range.

The sintering temperature for the nitride may be, for example, 1600°C or higher or 1700°C or higher. The sintering temperature for the nitride may be, for example, 2200°C or lower or 2000°C or lower. The sintering time for the nitride may be, for example, 1 hour or longer and also may be 30 hours or shorter. The atmosphere during sintering may be, for example, an inert gas atmosphere of nitrogen, helium, argon, or the like.

For the sintering, for example, a batch type furnace, a continuous type furnace, and the like may be used. Examples of the batch type furnace include a muffle furnace, a tube furnace, and an atmosphere furnace. Examples of the continuous type furnace include a rotary kiln, a screw conveyor furnace, a tunnel furnace, a belt furnace, a pusher furnace, and a koto-shaped continuous furnace.

The nitride sintered body may be molded into a desired shape, a desired thickness, and the like by cutting or the like, as necessary before the impregnation.

In the impregnation, a solution including a heat-curable composition is prepared in an impregnation apparatus, and a nitride sintered body is immersed in the solution to impregnate the heat-curable composition into the pores of the nitride sintered body. The solution including the heat-curable composition may also include a solvent in addition to the heat-curable composition or may include only the heat-curable composition. Examples of the solvent include an aliphatic alcohol, an ether alcohol, a glycol ether, a ketone, and a hydrocarbon.

The heat-curable composition contains at least one compound selected from the group consisting of a compound having a cyanate group, a compound having a bismaleimide group, and a compound having an epoxy group, and at

least one curing agent selected from the group consisting of a phosphine-based curing agent and an imidazole-based curing agent.

Examples of the compound having a cyanate group include dimethylmethylenebis(1,4-phenylene)biscyanate and bis(4-cyanatophenyl)methane. Dimethylmethylenebis(1,4-phenylene)biscyanate may be commercially purchased as, for example, TACN (manufactured by MITSUBISHI GAS CHEMICAL COMPANY, INC., trade name).

Examples of the compound having a bismaleimide group include N,N'-[(1-methylethylidene)bis[(p-phenylene)oxy(p-phenylene)]]bismaleim ide and 4,4'-diphenylmethanebismaleimide. N,N'-[(1-methylethylidene)bis[(p-phenylene)oxy(p-phenylene)]]bismale imide may be commercially purchased as, for example, BMI-80 (manufactured by K.I Chemical Industry Co., Ltd., trade name).

Examples of the compound having an epoxy group include 1,6-bis(2,3-epoxypropan-1-yloxy)naphthalene and a compound represented by the following General Formula (3). In General Formula (3), the value of n is not particularly limited but may be set to an integer of 0 or 1 or greater, and n is usually 1 to 10, and preferably 2 to 5. 1,6-Bis(2,3-epoxypropan-1-yloxy)naphthalene may be commercially purchased as, for example, HP-4032D (manufactured by DIC Corp., trade name).

[Chemical Formula 3]

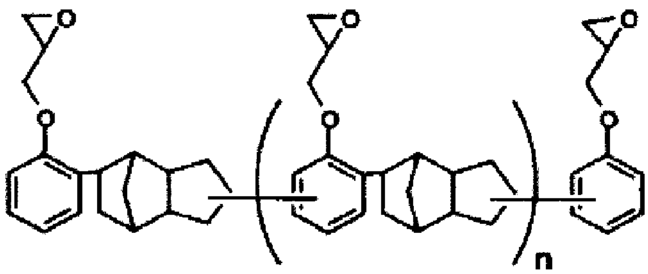

(3)

With regard to the heat-curable composition, the total amount of the compound having a cyanate group, the compound having a bismaleimide group, and the compound having an epoxy group may be 50% by mass or more, may be 70% by mass or more, may be 80% by mass or more, and may be 90% by mass or more, based on the total amount of the heat-curable composition.

The content of the compound having a cyanate group in the heat-curable composition may be, for example, 50 parts by mass or more, 60 parts by mass or more, or 70 parts by mass or more, with respect to 100 parts by mass of the total amount of the compound having a cyanate group and the compound having a bismaleimide group. When the content of the compound having a cyanate group in the heat-curable composition is in the above-described range, the curing reaction at the time of adhering the resulting composite to an adherend proceeds rapidly, and the composite has superior dielectric breakdown voltage after adhesion to an adherend. When the conditions for adhesion to an adherend are set the adhesion conditions in Examples, the effect of enhancing the dielectric breakdown voltage may be made more notable.

The content of the compound having a bismaleimide group in the heat-curable composition may be, for example, 15 parts by mass or more, 20 parts by mass or more, or 25 parts by mass or more, with respect to 100 parts by mass of the total amount of the compound having a cyanate group and the compound having a bismaleimide group. When the content of the compound having a bismaleimide group in the heat-curable composition is in the above-described range, the water absorption rate of the semi-cured product is decreased, and the reliability of a manufactured product may be enhanced.

The content of the compound having an epoxy group in the heat-curable composition may be, for example, 10 parts by mass or more, 20 parts by mass or more, or 30 parts by mass or more, with respect to 100 parts by mass of the total amount of the compound having a cyanate group and the compound having a bismaleimide group. The content of the compound having an epoxy group in the heat-curable composition may be, for example, 70 parts by mass or less or 60 parts by mass or less, with respect to 100 parts by mass of the total amount of the compound having a cyanate group and the compound having a bismaleimide group. When the content of the compound having an epoxy group in the heat-curable composition is in the above-described range, the decrease in the heat-curing initiation temperature of the heat-curable composition may be suppressed, and it becomes easier to impregnate the nitride sintered body with the heat-curable composition.

The curing agent may contain a phosphine-based curing agent and an imidazole-based curing agent.

A phosphine-based curing agent may accelerate a triazine production reaction based on trimerization of a

compound having a cyanate group or a cyanate resin. Examples of the phosphine-based curing agent include tetraphenylphosphonium tetra-p-tolylborate and tetraphenylphosphonium tetraphenylborate. Tetraphenylphosphonium tetra-p-tolylborate may be commercially purchased as, for example, TPP-MK (manufactured by HOKKO CHEMICAL INDUSTRY CO., LTD., trade name).

An imidazole-based curing agent produces oxazoline and accelerates a curing reaction of a compound having an epoxy group or an epoxy resin. Examples of the imidazole-based curing agent include 1-(1-cyanomethyl)-2-ethyl-4-methyl-1H-imidazole and 2-ethyl-4-methylimidazole.
1-(1-Cyanomethyl)-2-ethyl-4-methyl-1H-imidazole may be commercially purchased as, for example, 2E4MZ-CN (manufactured by SHIKOKU CHEMICALS CORPORATION, trade name).

The content of the phosphine-based curing agent may be, for example, 5 parts by mass or less, 4 parts by mass or less, or 3 parts by mass or less, with respect to 100 parts by mass of the total amount of the compound having a cyanate group, the compound having a bismaleimide group, and the compound having an epoxy group. The content of the phosphine-based curing agent may be, for example, 0.1 parts by mass or more or 0.5 parts by mass or more with respect to 100 parts by mass of the total amount of the compound having a cyanate group, the compound having a bismaleimide group, and the compound having an epoxy group. When the content of the phosphine-based curing agent is in the above-described range, production of the composite is easy, and the time required for the adhesion of an adherend using the composite may be further shortened.

The content of the imidazole-based curing agent may be, for example, 0.1 parts by mass or less, 0.05 parts by mass or less, or 0.03 parts by mass or less, with respect to 100 parts by mass of the total amount of the compound having a cyanate group, the compound having a bismaleimide group, and the compound having an epoxy group. The content of the imidazole-based curing agent may be, for example, 0.001 parts by mass or more or 0.005 parts by mass or more with respect to 100 parts by mass of the total amount of the compound having a cyanate group, the compound having a bismaleimide group, and the compound having an epoxy group. When the content of the imidazole-based curing agent is in the above-described range, production of the composite is easy, and the time required for the adhesion of an adherend using the composite may be further shortened.

The heat-curable composition may include other components other than the compound having a cyanate group, the compound having a bismaleimide group, the compound having an epoxy group, and the curing agent. Regarding the other components, for example, other resins such as a phenol resin, a melamine resin, a urea resin, and an alkyd resin; a silane coupling agent, a leveling agent, an anti-foaming agent, a surface adjusting agent, and a wetting dispersant may be further included. The content of these other components may be 20% by mass or less, may be 10% by mass or less, or may be 5% by mass or less, based on the total amount of the heat-curable composition.

The viscosity at 100°C of the solution including the above-mentioned heat-curable composition may be 50 mPa·second or less, 30 mPa·second or less, 20 mPa·second or less, 10 mPa·second or less, or 5 mPa·second. When the viscosity at 150°C of the solution is in the above-described range, preparation of the composite becomes easier. The viscosity at 100°C of the solution may be 3 mPa·second or greater. The viscosity at 100°C of the solution is preferably maintained to be 50 mPa.second or less for 5 hours or more in a state in which the temperature of the solution is maintained at 100°C. The viscosity at 100°C of the solution means a value measured using a rotary viscometer under the conditions of a shear rate of 10 (1/second).

The impregnation may be either under reduced pressure conditions or under pressurized conditions, or the impregnation may be carried out by combining impregnation under reduced pressure conditions and impregnation under pressurized conditions. The pressure inside the impregnation apparatus in the case of performing the impregnation under reduced pressure conditions may be, for example, 1000 Pa or less, 500 Pa or less, 100 Pa or less, 50 Pa or less, or 20 Pa or less. The pressure inside the impregnation apparatus in the case of performing the impregnation under pressurized conditions may be, for example, 1 MPa or greater, 3 MPa or greater, 10 MPa or greater, or 30 MPa or greater.

In the impregnation, a solution including a heat-curable composition is heated. By heating the solution in the following temperature range, the viscosity of the solution is adjusted, impregnation of the resin is promoted, and therefore, an excellent composite is obtained. The temperature for heating the solution exceeds the heating temperature for semi-curing. The upper limit of the temperature for heating the solution is a temperature lower than or equal to (the heating temperature for semi-curing + 20°C).

In the impregnation, a state in which the nitride sintered body is immersed in the solution including the heat-curable composition is maintained only for a predetermined time. This predetermined time may be, for example, 5 hours or longer, 10 hours or longer, 100 hours, or 150 hours or longer.

The semi-curing is heating the heat-curable composition impregnated into the nitride sintered body to semi-cure the heat-curable composition. Through the semi-curing, the semi-cured state of the heat-curable composition in the composite may be adjusted. The heating temperature at this time is 80°C to 130°C.

The semi-cured product obtainable by the semi-curing may contain at least one heat-curable resin comprising a cyanate resin, a bismaleimide resin, and an epoxy resin, and a curing agent. The semi-cured product may also contain, for example, other resins such as a phenol resin, a melamine resin, a urea resin, and an alkyd resin; and components

derived from a silane coupling agent, a leveling agent, an anti-foaming agent, a surface adjusting agent, a wetting dispersant, and the like, in addition to the above-mentioned heat-curable resin and the curing agent. The total content of the other resins and the components may be 20% by mass or less, may be 10% by mass or less, or may be 5% by mass or less, based on the total amount of the semi-cured product.

In the above-mentioned embodiment, the impregnation and the semi-curing have been described as separate steps. In another embodiment, the two do not necessarily have to be steps that are distinguishable from each other, as long as the desired actions of each step are provided. That is, in the middle of the impregnation, the heat-curable composition impregnated into the nitride sintered body may be semi-cured by adjusting the heating conditions. From the viewpoint of sufficiently impregnating the heat-curable composition into the nitride sintered body, it is preferable to provide the impregnation and the semi-curing separately.

The above-mentioned composite may be used, for example, for the production of a laminate such as a heat-conductive adhesive sheet. An embodiment of the laminate includes, for example, a first metal base material, an interlayer, and a second metal base material in this order. The first metal base material and the second metal base material are adhered by the interlayer, and the interlayer is a cured product of the above-mentioned composite.

The first metal base material and the second metal base material may be metal base materials that are identical to each other or may be different metal base materials. The first metal base material and the second metal base material may be, for example, copper, aluminum, or the like. The thicknesses of the first metal base material and the second metal base material may be each independently, for example, 0.035 mm or more, or 10 mm or less. The first metal base material and the second metal base material may form, for example, a circuit.

The above-mentioned laminate may be produced by, for example, the following method. An embodiment of the method for producing a laminate is a method for producing a laminate including a first metal base material, an interlayer, and a second metal base material in this order, and has disposing the first metal base material, the above-mentioned composite, and the second metal base material in this order, heating and pressurizing the assembly to cure the composite, and forming the interlayer.

In the method for producing a laminate, since the above-mentioned composite is used, the first metal base material and the second metal base material may be adhered in a short time period. The adhesion time may be adjusted to 2 hours or shorter, 1 hour or shorter, or 0.5 hours or shorter.

From the viewpoint of reducing the energy required for the production of a power module structure and an LED light-emitting device, it is required to shorten the adhesion time required for the production of a power module structure and an LED light-emitting device, particularly adhesion between a metal circuit and metal fins for heat dissipation. In order to shorten the above-mentioned adhesion time using a composite obtained by impregnating a conventional porous ceramic sintered body with a resin, for example, a means for producing an adhesive sheet in which the degree of polymerization of the resin has been increased in advance, may be conceived. However, in the case of this method, as a result of an increase in the solution viscosity brought by an increase in the degree of polymerization of the resin, it becomes difficult to impregnate the ceramic sintered body with the resin. As a result, a sufficient amount of the resin cannot be impregnated, and there is a risk that the adhesiveness and insulation properties of the resulting composite may become insufficient.

Compared to conventional composites, in the composite of the present disclosure, for example, the adhesion time required for the adhesion of a metal circuit and metal fins for heat dissipation may be shortened by selecting a composite whose dielectric breakdown voltage obtainable when cured under specific conditions is greater than 5 kV. When the composite of the present disclosure is implemented using a specific heat-curable composition, production of the composite becomes easier, and also, the adhesion time to an adherend may be shortened. By using a specific heat-curable resin and a specific curing agent in combination, even if relatively mild conditions are employed at the time of impregnating the nitride sintered body with the heat-curable composition, and impregnation is achieved in a circumstance where the viscosity of the solution is low, the curing time at the time of bringing the resulting composite to stage C may be shortened.

Thus, several embodiments have been described; however, the present disclosure is not intended to be limited to the above-described embodiments. Furthermore, the contents described for the above-mentioned embodiments can be applied to each other.

## Examples

Hereinafter, the contents of the present disclosure will be described in more detail with reference to Examples and Comparative Examples. However, the present disclosure is not intended to be limited to the following Examples.

(Example 1)

[Preparation of nitride sintered body having porous structure]

40.0% by mass of an amorphous boron nitride powder (manufactured by Denka Co., Ltd., oxygen content: 1.5%, boron nitride purity 97.6%, average particle size: 6.0 μm) and 60.0% by mass of a hexagonal boron nitride powder (manufactured by Denka Co., Ltd., oxygen content: 0.3%, boron nitride purity: 99.0%, average particle size: 30.0 μm) were respectively measured into a container, a sintering aid (boric acid, calcium carbonate) was added thereto, subsequently an organic binder and water were added and mixed therein, and then the mixture was dried and granulated to prepare a mixed powder of nitrides.

The mixed powder was charged into a mold and press-molded at a pressure of 5 MPa, and a molded body was obtained. Next, the molded body was compressed by applying a pressure of 20 to 100 MPa using a cold isostatic pressing (CIP) apparatus (manufactured by Kobe Steel, Ltd., trade name: ADW800). The compressed molded body was sintered by maintaining the molded body at 2000°C for 10 hours using a batch type high-frequency furnace (manufactured by Fuji Dempa Kogyo Co., Ltd., trade name: FTH-300-1H), and thereby a nitride sintered body was prepared. Incidentally, calcination was carried out by adjusting the inside of the furnace to a nitrogen atmosphere while causing nitrogen to flow into the furnace in a standard state at a flow rate of 10 L/min.

[Preparation of heat-curable composition]

80 parts by mass of a compound having a cyanate group, 20 parts by mass of a compound having a bismaleimide group, and 50 parts by mass of a compound having an epoxy group were measured into a container, 1 part by mass of a phosphine-based curing agent and 0.01 parts by mass of an imidazole-based curing agent were added to 100 parts by mass of the total amount of the three kinds of compounds, and the mixture was mixed. Meanwhile, since the epoxy resin was in a solid state at room temperature, the mixture was mixed in a stated of being heated to about 80°C. The viscosity at 100°C of the resulting heat-curable composition was 10 mPa·second.

For the preparation of the heat-curable composition, the following compounds were used.

<Compound having specific functional group>

Compound having a cyanate group: Dimethylmethylenebis(1,4-phenylene)biscyanate (manufactured by MITSUBISHI GAS CHEMICAL COMPANY, INC., trade name: TA-CN)

Compound having a bismaleimide group: N,N'-[(1-methylethylidene)bis[(p-phenylene)oxy(p-phenylene)]]bismale imide (manufactured by K.I Chemical Industry Co., Ltd., trade name: BMI-80)

Compound having an epoxy group: 1,6-Bis(2,3-epoxypropan-1-yloxy)naphthalene (manufactured by DIC Corp., trade name: HP-4032D)

Compound having a benzoxazine group: Bisphenol F type benzoxazine (manufactured by SHIKOKU CHEMICALS CORPORATION, trade name: F-a type benzoxazine)

<Curing agent>

Phosphine-based curing agent: Tetraphenylphosphonium tetra-p-tolylborate (manufactured by HOKKO CHEMICAL INDUSTRY CO., LTD., trade name: TPP-MK)

Imidazole-based curing agent: 1-(1-Cyanomethyl)-2-ethyl-4-methyl-1H-imidazole (manufactured by SHIKOKU CHEMICALS CORPORATION, trade name: 2E4MZ-CN)

Metal catalyst: Bis(2,4-pentanedionato)zinc(II) (Tokyo Chemical Industry Co., Ltd.)

[Preparation of composite]

The nitride sintered body prepared as described above was impregnated with the heat-curable composition prepared as described above, by the following method. First, the nitride sintered body and the heat-curable composition contained in the container were placed in a vacuum heating impregnation apparatus (manufactured by KYOSIN ENGINEERING CORPORATION, trade name: G-555AT-R). Next, the interior of the apparatus was purged for 10 minutes under the conditions of temperature: 100°C and pressure: 15 Pa. After purging, the nitride sintered body was immersed in the heat-curable composition for 40 minutes while being maintained under the same conditions, and the heat-curable composition was impregnated into the nitride sintered body.

Subsequently, the container containing the nitride sintered body and the heat-curable composition was taken out and was placed in a pressure heating impregnation apparatus (manufactured by KYOSIN ENGINEERING CORPORATION, trade name: HP-4030AA-H45), the container was maintained for 120 minutes under the conditions of temperature: 130°C and pressure: 3.5 MPa, and thus the heat-curable composition was further impregnated into the nitride sintered body. Subsequently, the nitride sintered body was taken out from the apparatus and was heated for 8 hours under the conditions of temperature: 120°C and atmospheric pressure, the heat-curable composition was semi-cured to prepare a composite. The content of the semi-cured product was 25% to 68% by volume.

[Measurement of dielectric breakdown voltage]

The composite obtained as described above was prepared into a laminate, which was obtained by disposing the composite between two sheets of copper plates, heating and pressurizing the assembly for 5 minutes under the conditions of 200°C and 10 MPa, and further heating the assembly for 2 hours under the conditions of 200°C and atmospheric pressure. On one surface of the laminate thus obtained, an etching resist agent was screen-printed so as to have a circular shape having a diameter of 20 mm, and on the other surface of the laminate, the etching resist agent was screen-printed over the entire surface. After printing, the etching resist agent was irradiated with ultraviolet radiation to cure, and resist was formed. Next, the copper plate on the side on which a circular-shaped resist had been formed was etched with a cupric chloride solution, and a circular-shaped copper circuit having a diameter of 20 mm was formed on one surface of the laminate. As such, the laminate on which a circular-shaped copper circuit was formed was obtained, which was an object of measurement. The dielectric breakdown voltage was measured for the laminate thus obtained, using a withstanding voltage tester (manufactured by KIKUSUI ELECTRONICS CORPORATION, apparatus name: TOS-8700) according to JIS C2110-1:2016. From the measurement results, the insulation properties were evaluated according to the following criteria. The results are shown in Table 1.

A: The dielectric breakdown voltage is 10 kV or greater.
B: The dielectric breakdown voltage is 5 kV or greater and less than 10 kV.
C: The dielectric breakdown voltage is less than 5 kV.

[Evaluation of 90° peelability and adhesiveness]

The composite obtained as described above was prepared into a laminate, which was obtained by disposing the composite between two sheets of copper plates, heating and pressurizing the assembly for 5 minutes under the conditions of 200°C and 10 MPa, and further heating for 2 hours under the conditions of 200°C and atmospheric pressure, and this laminate was used as an object of measurement. A 90° peeling test was performed according to JIS K 6854-1:1999, "Adhesives - Determination of peel strength of bonded assemblies", and the area of a cohesive fracture portion was measured. From the measurement results, adhesiveness was evaluated according to the following criteria. The results are shown in Table 1.

A: The area of the cohesive fracture portion is 70% by area or more.
B: The area of the cohesive fracture portion is 30% by area or more and less than 70% by area.
C: The area of the cohesive fracture portion is less than 30% by area.

[Measurement of thermal resistance and evaluation of heat dissipation properties]

The composite obtained as described above was prepared into a laminate, which was obtained by disposing the composite between two sheets of copper plates, heating and pressurizing the assembly for 5 minutes under the conditions of 200°C and 10 MPa, and further heating the assembly for 2 hours under the conditions of 200°C and atmospheric pressure, and this was used as an object of measurement. Thermal resistance was measured according to ASTM-D5470. From the measurement results, heat dissipation properties were evaluated according to the following criteria. The results are shown in Table 1.

A: Thermal resistance is less than 0.40 K/W.
B: Thermal resistance is 0.40 K/W or greater and less than 0.50 K/W.
C: Thermal resistance is 0.50 K/W or greater.

(Examples 2 to 7 and Comparative Examples 1 to 3)

Composites were prepared in the same manner as in Example 1, except that the types and blending ratios of

the compound having a specific functional group and the curing agent, and the content of the semi-cured product were changed as shown in Table 1, and evaluation of the dielectric breakdown voltage, insulation properties, 90° peelability, adhesiveness, thermal resistance, and heat dissipation properties was carried out. Examples 2 to 4 and Comparative Examples 1 to 3 are provided for illustrative purposes.

[Tabel 1]

| | | | Example 1 | Example 2 | Example 3 | Example 4 | Example 5 | Example 6 | Example 7 | Comparative Example 1 | Comparative Example 2 | Comparative Example 3 |
|---|---|---|---|---|---|---|---|---|---|---|---|---|
| Heat-curable composition | Compound having specific functional group | Compound having cyanate group | 80 | 50 | 100 | 50 | 80 | 80 | 80 | 20 | 80 | 50 |
| | | Compound having bismaleimide group | 20 | 50 | 0 | 50 | 20 | 20 | 20 | 20 | 20 | 50 |
| | | Compound having epoxy group | 50 | 0 | 0 | 0 | 50 | 50 | 50 | 0 | 50 | 0 |
| | | Compound having benzoxazine group | 0 | 0 | 0 | 1 | 0 | 0 | 0 | 60 | 0 | 0 |
| | Curing agent | Phosphine-based curing accelerator | 1 | 1 | 1 | 0 | 1 | 1 | 1 | 1 | 1 | 1 |
| | | Imidazole-based curing accelerator | 0.01 | 0 | 0.01 | 0.1 | 1 | 0.01 | 0.01 | 0 | 0.01 | 0 |
| | | Metal catalyst | 0 | 0 | 0 | 0 | 0.001 | 0 | 0 | 1 | 0 | 0 |
| Content of semi-cured product [volume%] | | | 30 | 40 | 50 | 45 | 35 | 25 | 68 | 40 | 15 | 75 |
| Dielectric breakdown voltage [kV] | | | 10 | 6 | 10 | 7 | 10 | 10 | 10 | 4 | 4 | 4 |
| Insulation properties | | | A | B | A | B | A | A | A | C | C | c |
| Cohesive fracture area upon 90° peeling [area%] | | | 90 | 95 | 96 | 97 | 98 | 60 | 90 | 20 | 15 | 95 |
| Adhesiveness | | | A | A | A | A | A | B | A | C | C | A |
| Thermal resistance [K/W] | | | 0.36 | 0.35 | 0.34 | 0.36 | 0.35 | 0.36 | 0.45 | 0.54 | 0.35 | 0.55 |
| Heat dissipation properties | | | A | A | A | A | A | A | B | C | A | C |

## Industrial Applicability

According to the present disclosure, a composite having excellent adhesiveness to an adherend and excellent insulation properties after adhesion to the adherend, and a method for producing the composite may be provided.

## Claims

1. A composite comprising a nitride sintered body having a porous structure; and a semi-cured product of a heat-curable composition impregnated into the nitride sintered body,

   wherein the semi-cured product has a structural unit derived from a cyanate group, a structural unit derived from a bismaleimide group, and a structural unit derived from an epoxy group,
   wherein the content of the semi-cured product is 20% to 70% by volume,
   wherein a dielectric breakdown voltage obtainable after disposing the composite between adherends, heating and pressurizing the composite for 5 minutes under the conditions of 200°C and 10 MPa, and further heating the composite for 2 hours under the conditions of 200°C and atmospheric pressure, is greater than 5 kV.

2. The composite according to claim 1, wherein the semi-cured product comprises at least one curing agent selected from the group consisting of a phosphine-based curing agent and an imidazole-based curing agent.

3. A method for producing a composite having a nitride sintered body having a porous structure and a semi-cured product of a heat-curable composition impregnated into the nitride sintered body,
   the method comprising:

   impregnating a nitride sintered body having a porous structure with a heat-curable composition; and
   heating the heat-curable composition to a heating temperature of 80°C to 130°C to be semi-cured,
   wherein the impregnating is a step of impregnating the nitride sintered body with the heat-curable composition by setting the temperature of the heat-curable composition to be higher than the heating temperature and lower than or equal to (the heating temperature + 20°C), and
   the heat-curable composition comprises a compound having a cyanate group, a compound having a bismaleimide group, a compound having an epoxy group, and at least one curing agent selected from the group consisting of a phosphine-based curing agent and an imidazole-based curing agent,
   wherein the content of the semi-cured product is 20% to 70% by volume.

4. A laminate comprising a first metal base material, an interlayer, and a second metal base material in this order,

   wherein the first metal base material and the second metal base material are adhered by the interlayer, and
   the interlayer is a cured product of the composite according to claim 1 or 2.

5. A method for producing a laminate including a first metal base material, an interlayer, and a second metal base material in this order,
   the method comprising disposing the first metal base material, the composite according to claim 1 or 2, and the second metal base material in this order, heating and pressurizing the assembly to cure the composite, and forming the interlayer.

## Patentansprüche

1. Verbundwerkstoff, umfassend einen Nitrid-Sinterkörper mit einer porösen Struktur; und ein halbgehärtetes Produkt aus einer wärmehärtbaren Zusammensetzung, welches in den Nitrid-Sinterkörper imprägniert ist,

   wobei das halbgehärtete Produkt eine von einer Cyanatgruppe abgeleitete Struktureinheit, eine von einer Bismaleimidgruppe abgeleitete Struktureinheit und eine von einer Epoxidgruppe abgeleitete Struktureinheit aufweist,
   wobei der Gehalt des halbgehärteten Produkts 20 bis 70 Volumen-% beträgt,
   wobei die dielektrische Durchschlagsspannung, welche nach dem Anordnen des Verbundwerkstoffs zwischen Haftvermittlern, Erwärmen und Druckbeaufschlagung des Verbundwerkstoffs für 5 Minuten unter den Bedingungen von 200°C und 10 MPa, und weiterem Erwärmen des Verbundwerkstoffs für 2 Stunden unter den Bedingungen von 200°C und atmosphärischem Druck erhältlich ist, größer als 5 kV ist.

**2.** Verbundwerkstoff gemäß Anspruch 1, wobei das halbgehärtete Produkt mindestens ein Härtungsmittel umfasst, ausgewählt aus der Gruppe bestehend aus einem phosphinbasierten Härtungsmittel und einem imidazolbasierten Härtungsmittel.

**3.** Verfahren zur Herstellung eines Verbundwerkstoffs mit einem Nitrid-Sinterkörper mit einer porösen Struktur und einem halbgehärteten Produkt aus einer wärmehärtbaren Zusammensetzung, welches in den Nitrid-Sinterkörper imprägniert ist,
das Verfahren umfassend:

Imprägnieren eines Nitrid-Sinterkörpers mit einer porösen Struktur mit einer wärmehärtbaren Zusammensetzung; und
Erwärmen der wärmehärtbaren Zusammensetzung auf eine Erwärmungstemperatur von 80°C bis 130°C, um halbgehärtet zu werden,
wobei das Imprägnieren ein Schritt des Imprägnierens des Nitrid-Sinterkörpers mit der wärmehärtbaren Zusammensetzung ist, indem die Temperatur der wärmehärtbaren Zusammensetzung höher als die Erwärmungstemperatur und niedriger als oder gleich (die Erwärmungstemperatur + 20°C) eingestellt wird, und
die wärmehärtbare Zusammensetzung eine Verbindung mit einer Cyanatgruppe, eine Verbindung mit einer Bismaleimidgruppe, eine Verbindung mit einer Epoxygruppe und mindestens ein Härtungsmittel ausgewählt aus der Gruppe bestehend aus einem phosphinbasierten Härtungsmittel und einem imidazolbasierten Härtungsmittel umfasst,
wobei der Gehalt des halbgehärteten Produkts 20 bis 70 Volumen-% beträgt.

**4.** Laminat, umfassend ein erstes metallisches Grundmaterial, eine Zwischenschicht und ein zweites metallisches Grundmaterial in dieser Reihenfolge, wobei das erste metallische Grundmaterial und das zweite metallische Grundmaterial durch die Zwischenschicht angehaftet sind, und
die Zwischenschicht ein gehärtetes Produkt des Verbundwerkstoffs gemäß Anspruch 1 oder 2 ist.

**5.** Verfahren zur Herstellung eines Laminats, enthaltend ein erstes metallisches Grundmaterial, eine Zwischenschicht und ein zweites metallisches Grundmaterial in dieser Reihenfolge,
das Verfahren umfassend das Anordnen des ersten metallischen Grundmaterials, des Verbundwerkstoffs gemäß Anspruch 1 oder 2 und des zweiten metallischen Grundmaterials in dieser Reihenfolge, Erwärmen und Druckbeaufschlagen der Anordnung, um den Verbundwerkstoff auszuhärten, und Bilden der Zwischenschicht.

**Revendications**

**1.** Composite comprenant un corps fritté en nitrure présentant une structure poreuse ; et un produit semi-durci d'une composition thermodurcissable imprégnée dans le corps fritté en nitrure,

dans lequel le produit semi-durci présente un motif de structure dérivé d'un groupe cyanate, un motif de structure dérivé d'un groupe bismaléimide, et un motif de structure dérivé d'un groupe époxy,
dans lequel la teneur en produit semi-durci est de 20 % à 70 % en volume,
dans lequel une tension de claquage diélectrique pouvant être obtenue après le placement du composite entre des parties adhérées, le chauffage et la mise sous pression du composite pendant 5 minutes dans des conditions de 200 °C et 10 MPa, et le chauffage supplémentaire du composite pendant 2 heures dans les conditions de 200 °C et de pression atmosphérique, est supérieure à 5 kV.

**2.** Composite selon la revendication 1, dans lequel le produit semi-durci comprend au moins un agent de durcissement sélectionné dans le groupe consistant en un agent de durcissement à base de phosphine et un agent de durcissement à base d'imidazole.

**3.** Procédé de production d'un composite présentant un corps fritté en nitrure présentant une structure poreuse et un produit semi-durci d'une composition thermodurcissable imprégnée dans le corps fritté en nitrure,
le procédé comprenant :

l'imprégnation d'un corps fritté en nitrure présentant une structure poreuse avec une composition thermodurcissable ; et
le chauffage de la composition thermodurcissable à une température de chauffage de 80 °C à 130 °C pour être semi-durcie,
dans lequel l'imprégnation est une étape d'imprégnation du corps fritté en nitrure avec la composition thermodurcissable en réglant la température de la composition thermodurcissable pour être supérieure à la température de chauffage et inférieure ou égale à (la température de chauffage + 20 °C), et
la composition thermodurcissable comprend un composé présentant un groupe cyanate, un composé présentant un groupe bismaléimide, un composé présentant un groupe époxy, et au moins un agent de durcissement sélectionné dans le groupe consistant en un agent de durcissement à base de phosphine et un agent de durcissement à base d'imidazole,
dans lequel la teneur en produit semi-durci est de 20 % à 70 % en volume.

**4.** Stratifié comprenant un premier matériau métallique de base, une couche intermédiaire et un second matériau métallique de base dans cet ordre,

dans lequel le premier matériau métallique de base et le second matériau métallique de base sont collés par la couche intermédiaire, et
la couche intermédiaire est un produit durci du composite selon la revendication 1 ou la revendication 2.

**5.** Procédé de production d'un stratifié incluant un premier matériau métallique de base, une couche intermédiaire et un second matériau métallique de base dans cet ordre,
le procédé comprenant la disposition du premier matériau métallique de base, du composite selon la revendication 1 ou la revendication 2, et du second matériau métallique de base dans cet ordre, le chauffage et la mise sous pression de l'assemblage pour durcir le composite, et la formation de la couche intermédiaire.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3428223 A
- WO 2014196496 A